# EUROPEAN PATENT APPLICATION

(11) **EP 4 746 636 A1**
(43) Date of publication of application: **20.05.2026**
(21) Application number: 24943667.6
(22) Date of filing: 01.11.2024
(51) Int. Cl.: H10D 86/00

(54) **DISPLAY PANEL AND DISPLAY DEVICE**

(30) Priority: 02.09.2024 CN 202411217820
(71) Applicant: Wuhan China Star Optoelectronics Semiconductor Display Technology Co., Ltd., Wuhan, Hubei 430079 (CN)
(72) Inventor: CHEN, Fei, Wuhan, Hubei 430079 (CN)
(74) Representative: Studio Torta S.p.A.
(86) International application number: PCT/CN2024/129307
(87) International publication number: WO 2026/044910

(57) **Abstract**

The present application provides a display panel and a display device. A light shielding layer of the display panel includes a first light shielding portion, a second light shielding portion and a third light shielding portion. The first light shielding portion can shield a first active portion of a drive transistor, the second light shielding portion can shield a third active portion of a compensation transistor, and the third light shielding portion can shield a fourth active portion of a first initialization transistor, thereby improving the photosensitivity and electrical properties of the compensation transistor and the first initialization transistor.

## Description

### TECHNICAL FIELD

The present application relates to display technologies, and in particular to a display panel and a display device.

### BACKGROUND

With the development of display devices, there are higher and higher requirements for power consumption and a screen-to-body ratio of a display device. In order to reduce the power consumption and increase the screen-to-body ratio, the low-temperature polysilicon oxide (LTPO) technology may be applied in a display device, so that a drive circuit of the display device includes both low-temperature polysilicon thin-film transistors and oxide thin-film transistors. Thus, the drive circuit has the advantages of the two types of thin-film transistors, so that power consumption and leakage current could be reduced. However, a display device using the LTPO technology usually has a large number of layers. Accordingly, it is necessary to use a large number of masks in a process of manufacturing the display device. Thus, the process may be complex and costly. In order to reduce the number of masks, some gate layers and insulating layers may be removed in a display device, but this may result in lack of bottom gates of the oxide thin-film transistors in the display device, so that photosensitivity and electrical properties of the oxide thin-film transistors may deteriorate.

Therefore, the display device using LTPO technology suffer from technical problems such as deteriorated photosensitivity and electrical properties due to the lack of a bottom gate in the oxide thin-film transistor.

### SUMMARY

This application provides a display panel and a display device to alleviate the technical problem of degraded photosensitivity and electrical properties caused by the absence of the bottom gate of the oxide thin-film transistor in the display device using LTPO technology.

The technical solution provided by this application is as follows:

In a first aspect, the embodiments of the present application provide a display panel includes a substrate and a plurality of sub-pixels disposed on the substrate, each of the sub-pixels includes a drive transistor, a switch transistor, a compensation transistor and a first initialization transistor, the switch transistor and the drive transistor are connected to a first node, an electrode of the compensation transistor, an electrode of the first initialization transistor and the drive transistor are connected to a second node, and another electrode of the compensation transistor and the drive transistor are connected to a third node, the display panel further includes:
a light shielding layer disposed on one side of the substrate;
a first semiconductor layer disposed on a side of the light shielding layer away from the substrate, the first semiconductor layer includes a first active portion of the drive transistor and a second active portion of the switch transistor; and
a second semiconductor layer disposed on a side of the first semiconductor layer away from the substrate, the second semiconductor layer includes a third active portion of the compensation transistor and a fourth active portion of the first initialization transistor;
the light shielding layer includes a first light shielding portion disposed opposite to the first active portion, a second light shielding portion disposed opposite to the third active portion, and a third light shielding portion disposed opposite to the fourth active portion; the light shielding layer further includes a first connecting line extending along a first direction and a second connecting line extending along a second direction, the first direction and the second direction are different, the first connecting line is connected between two first light shielding portions disposed adjacent to each other in the first direction, and the second connecting line is connected between two first light shielding portions disposed adjacent to each other in the second direction.

In a second aspect, the embodiments of the present application further provide a display device including a display panel as described in any of the foregoing embodiments.

### BRIEF DESCRIPTION OF THE DRAWINGS

To more clearly illustrate the technical solutions in the embodiments or prior art, the accompanying drawings used in the description of the embodiments or prior art will be briefly introduced below. Obviously, the drawings described below are merely some embodiments of the invention. For those skilled in the art, other drawings can be obtained based on these drawings without any creative effort.
FIG. 1 is a schematic diagram of a comparative display device with respect to embodiments of the present application.
FIG. 2 is a schematic diagram of another comparative display device with respect to embodiments of the present application.
FIG. 3 is a schematic diagram of yet another comparative display device with respect to embodiments of the present application.
FIG. 4 is a schematic diagram of layers of a display panel according to some embodiments of the present application.
FIG. 5 is a circuit diagram of a sub-pixel of a display panel according to some embodiments of the present application.
FIG. 6 illustrates first stacking of layers of a display panel according to some embodiments of the present application.
FIG. 7 illustrates second stacking of layers of a display panel according to some embodiments of the present application.
FIG. 8 is a decomposition diagram of a light shielding layer of the display panel in FIG. 6.
FIG. 9 is a decomposition diagram of a light shielding layer of the display panel in FIG. 7.
FIG. 10 is a decomposition diagram of a first semiconductor layer of the display panel in FIG. 6.
FIG. 11 is a decomposition diagram of a first gate layer of the display panel in FIG. 6.
FIG. 12 is a decomposition diagram of a second semiconductor layer of the display panel in FIG. 6.
FIG. 13 is a decomposition diagram of a second gate layer of the display panel in FIG. 6.
FIG. 14 is a decomposition diagram of a first source-drain layer of the display panel in FIG. 6.
FIG. 15 is a decomposition diagram of a second source-drain layer of the display panel in FIG. 6.
FIG. 16 is a decomposition diagram of first via holes of the display panel in FIG. 6.
FIG. 17 is a decomposition diagram of second via holes of the display panel in FIG. 6.
FIG. 18 is a decomposition diagram of third via holes of the display panel in FIG. 6.
FIG. 19 is a decomposition diagram of fourth via holes of the display panel in FIG. 6.

### DETAILED DESCRIPTION

The following description of the embodiments is with reference to the accompanying drawings, which illustrate specific embodiments that can be implemented in the present application. Directional terms mentioned in the present application, such as "upper", "lower", "front", "back", "left", "right", "inner", "outer" and "side" are for referring to the accompanying drawings only. Therefore, the directional terms used are to illustrate and describe, but not to limit, the present application. In the accompanying drawings, units with similar structures are represented by the same numbers. In the accompanying drawings, the thickness of some layers and regions has been exaggerated for clarity and ease of description. That is, the dimensions and thickness of each component shown in the accompanying drawings are shown arbitrarily, and will not be a limit of the present application.

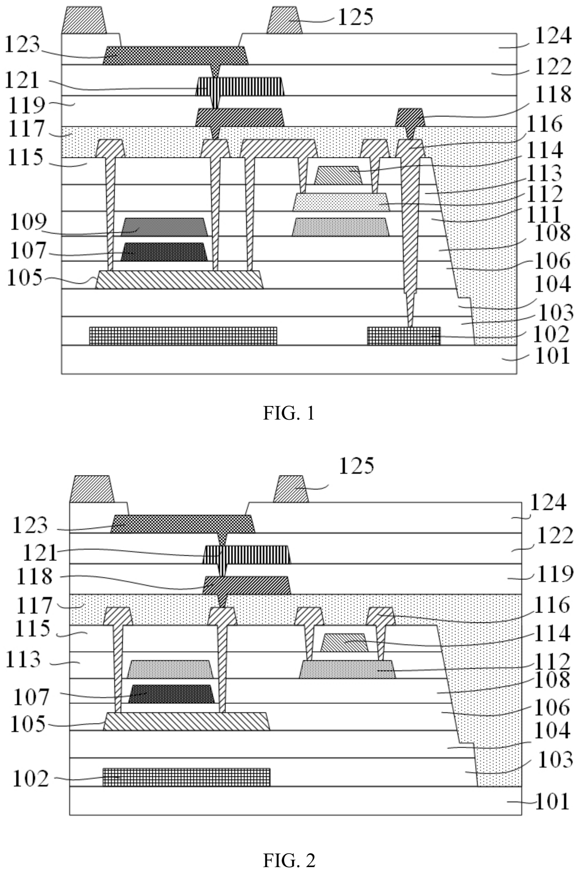

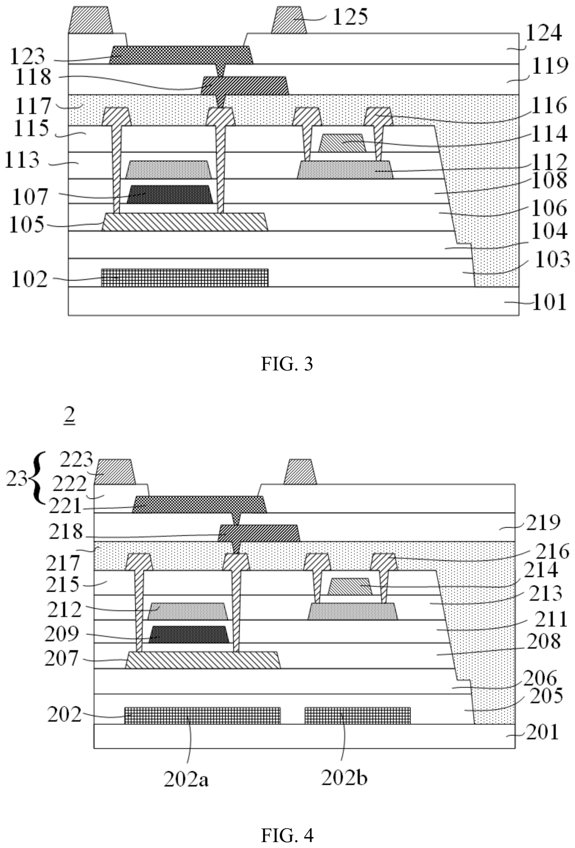

As an introduction to the embodiments of the present application, some comparative display devices are provided in FIG. 1 to FIG. 3. FIG. 1 is a schematic diagram of a comparative display device with respect to embodiments of the present application, FIG. 2 is a schematic diagram of another comparative display device with respect to embodiments of the present application, and FIG. 3 is a schematic diagram of yet another comparative display device with respect to embodiments of the present application. In FIG. 1, a comparative display device using the LTPO technology includes a substrate 101, a light shielding film 102, a barrier film 103, a buffer film 104, a low temperature polysilicon film 105, a first gate insulating film 106, a first gate film 107, a second gate insulating film 108, a second gate film 109, a first interlayer insulating film 111, an oxide semiconductor film 112, a third gate insulating film113, a third gate film 114, a second interlayer insulating film 115, a first source-drain film 116, a first planarization film 117, a second source-drain film 118, a second planarization film 119, a third source-drain film 121, a third planarization film 122, an anode film 123, a pixel definition film 124, and a support film 125. As can be seen from FIG. 1, the comparative display device includes three source-drain films and three gate films, so that the comparative display device needs to be formed using 16 masks, which results in a relatively complex process and high cost.

In order to solve the problem of complex process in the comparative display device, one layer of the gate film and one layer of the insulating film are removed in another comparative display device. As shown in FIG. 2, it can be seen that the second gate film 109 and the second gate insulating film 108 are removed in the comparative display device, so that the number of masks can be reduced to 14. However, there are still problems such as a large number of masks, a complex process and a high cost.

In order to solve the problem of complex process in the comparative display device, a layer of source-drain film and a layer of insulating film are further removed in another comparative display device. As shown in FIG. 3, by removing the third source-drain film 121 and the third planarization film 122, the number of masks can be reduced to 13. However, it can be seen from FIG. 2 and FIG. 3 that there is no shielding under the oxide semiconductor film 112, resulting in the missing of bottom gate of the oxide thin film transistor, and the photosensitivity and electrical properties of the thin film transistor are deteriorated.

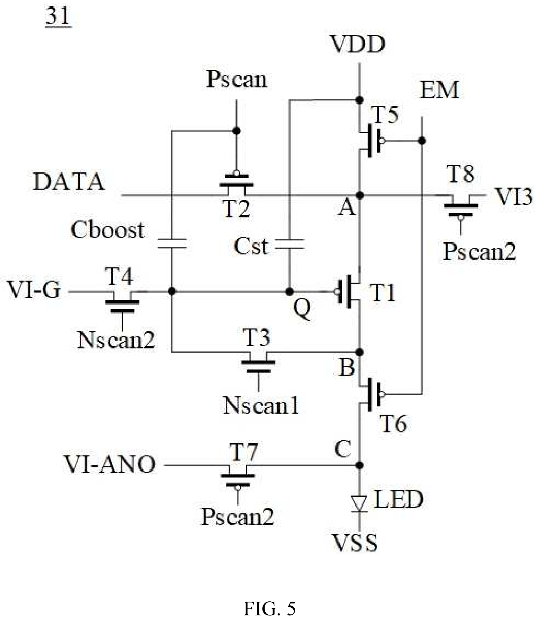

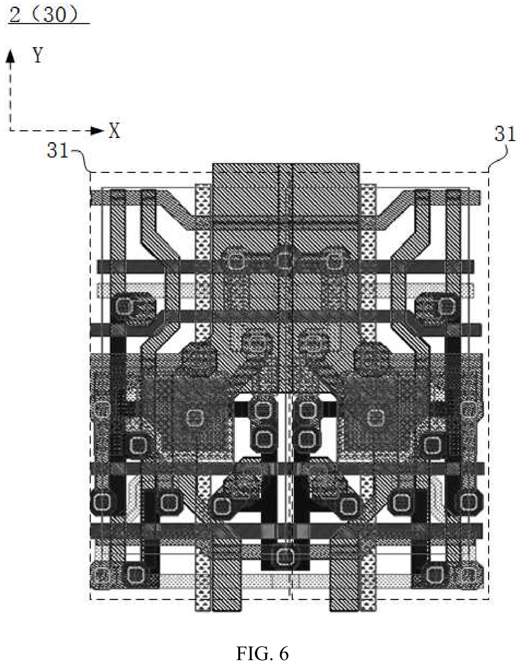

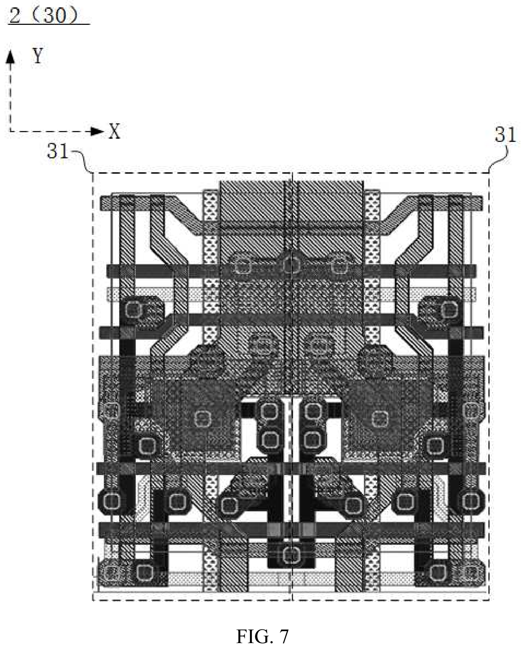

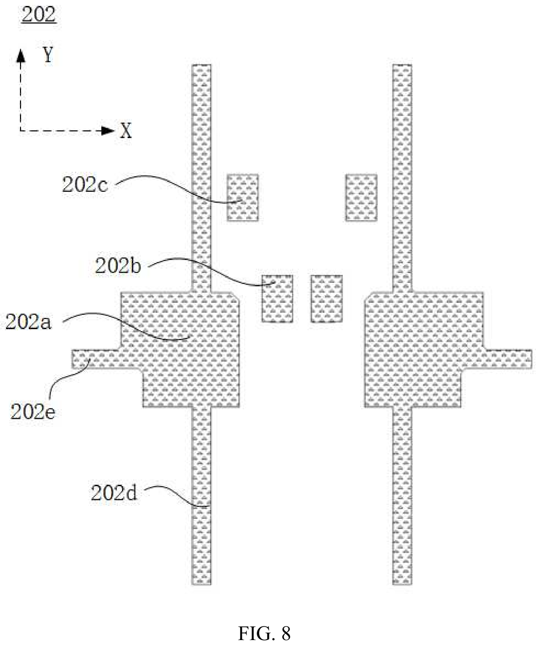

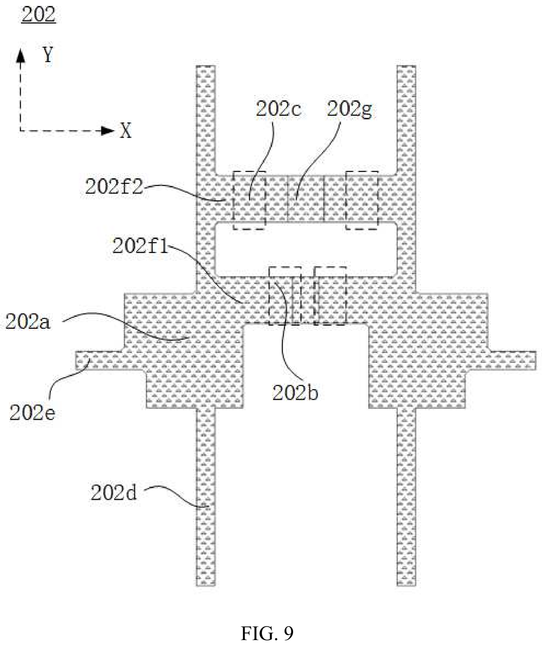

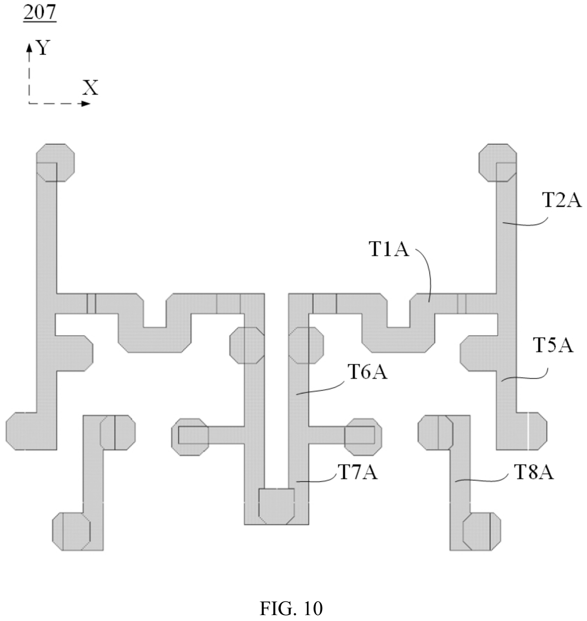

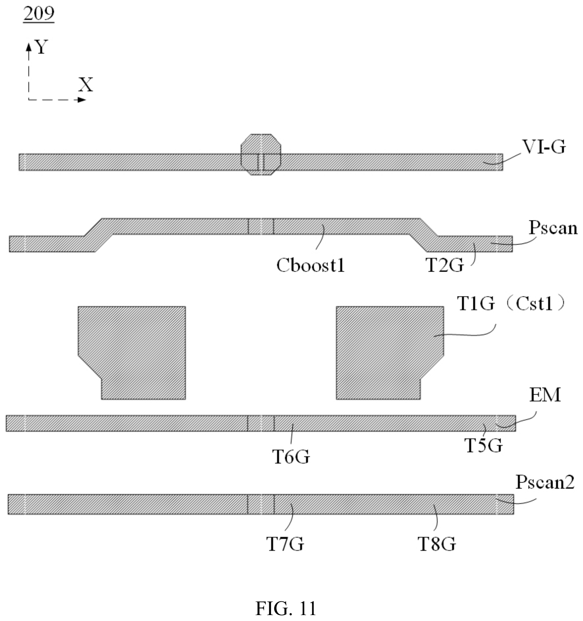

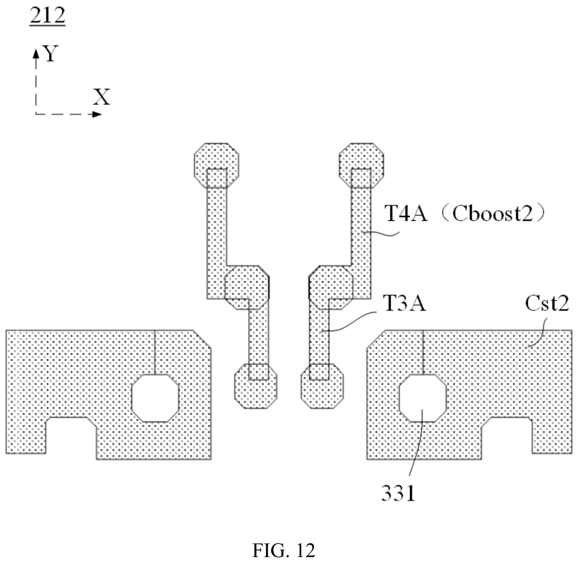

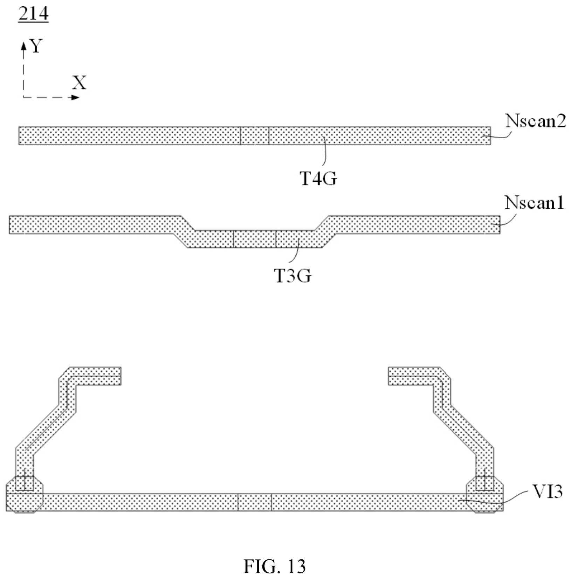

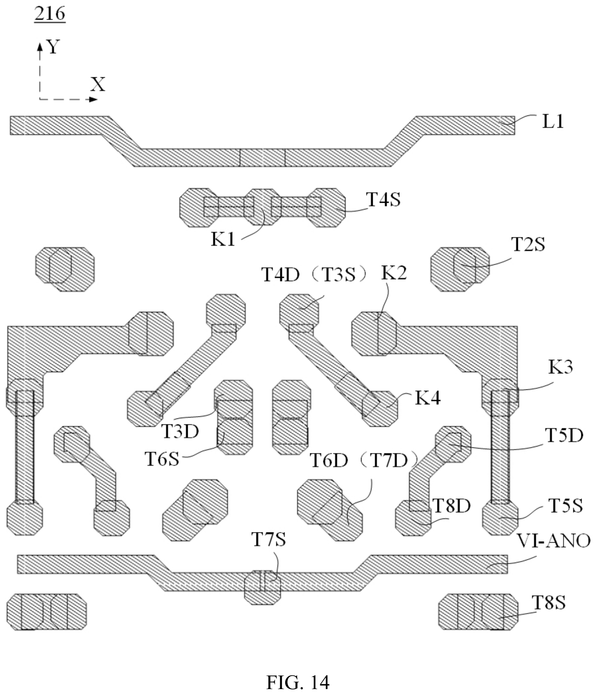

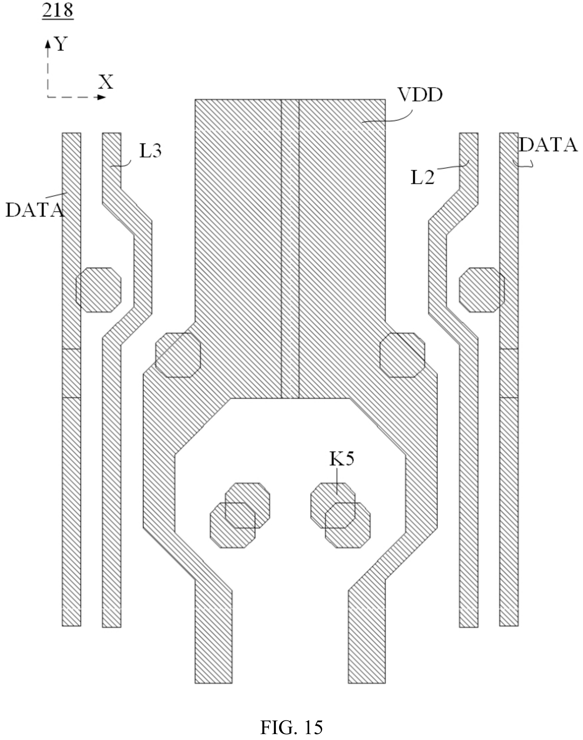

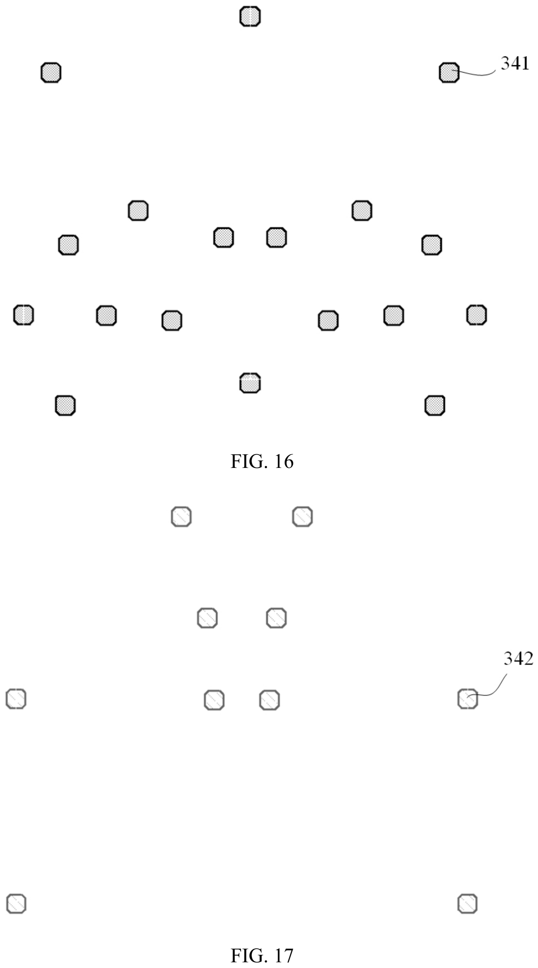

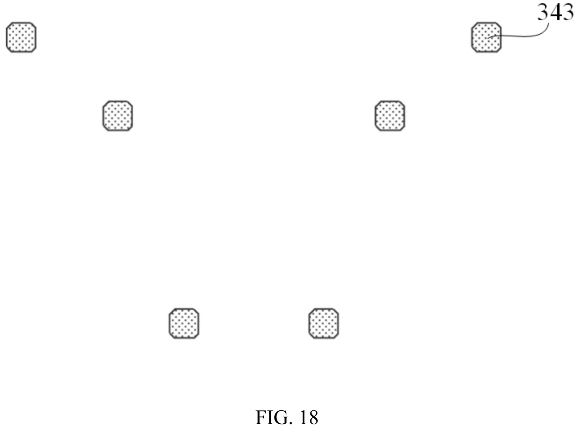

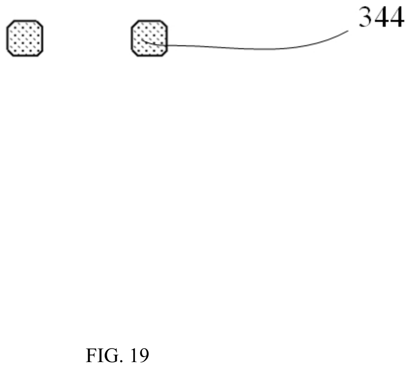

For this reason, the present application provides a display panel and a display device, please refer to FIG. 1 to FIG. 19. FIG. 4 is a schematic diagram of a layer of a display panel according to one or more embodiments of the present application. FIG. 5 is a circuit diagram of a sub-pixel of a display panel according to one or more embodiments of the present application. FIG. 6 is a first stacking diagram of each layer of a display panel according to one or more embodiments of the present application. FIG. 7 is a second stacking diagram of a display panel according to one or more embodiments of the present application. FIG. 8 is a decomposition diagram of the light shielding layer of the display panel in FIG. 6. FIG. 9 is a decomposition diagram of the light shielding layer of the display panel in FIG. 7. FIG. 10 is a decomposition diagram of the first semiconductor layer of the display panel in FIG. 6. FIG. 11 is a decomposition diagram of the first gate layer of the display panel in FIG. 6. FIG. 12 is a decomposition diagram of the second semiconductor layer of the display panel in FIG. 6. FIG. 13 is a decomposition diagram of the second gate layer of the display panel in FIG. 6. FIG. 14 is a decomposition diagram of the first source-drain layer of the display panel in FIG. 6. FIG. 15 is a decomposition diagram of the second source-drain layer of the display panel in FIG. 6. FIG. 16 is a decomposition diagram of the first via hole of the display panel in FIG. 6. FIG. 17 is a decomposition diagram of the second via hole of the display panel in FIG. 6. FIG. 18 is a decomposition diagram of a third via hole of the display panel in FIG. 6. FIG. 19 is a decomposition diagram of a fourth via hole of the display panel in FIG. 6.

It should be noted that the difference between the display panel in FIG. 6 and the display panel in FIG. 7 in embodiments of the present application lies in the different designs of the light shielding layers, and the designs of other layers on the display panel can be the same. Therefore, in the following decomposition diagrams of the FIG. 6, except for the different light shielding layers, the decomposition diagram of other layers can also be used as decomposition diagrams of the corresponding layers of the display panel in FIG. 7. For example, the decomposition diagram of the light shielding layer of the display panel in FIG. 7 can be as shown in FIG. 9, and other layers can similarly refer to other decomposition diagrams, which will not be repeated here.

An embodiment of the present application provides a display panel, as shown in FIG. 4 to FIG. 19, the display panel 2 includes a substrate 201 and a plurality of sub-pixels 31 disposed on the substrate 201, each sub-pixel 31 includes a switch transistor T2, a drive transistor T1, a compensation transistor T3 and a first initialization transistor T4, the switch transistor T2 and the drive transistor T1 are connected to a first node A; one electrode of the compensation transistor T3, one electrode of the first initialization transistor T4 and the drive transistor T1 are connected to a second node Q, and another electrode of the compensation transistor T3 and the drive transistor T1 are connected to a third node B.

The display panel 2 further includes a light shielding layer 202, a first semiconductor layer 207 and a second semiconductor layer 212 disposed on the substrate 201. The light shielding layer 202 is disposed between the substrate 201 and the first semiconductor layer 207, and the first semiconductor layer 207 is disposed between the light shielding layer 202 and the second semiconductor layer 212.

The first semiconductor layer 207 is disposed on a side of the light shielding layer 202 away from the substrate 201. The first semiconductor layer 207 includes a first active portion T1A of the drive transistor T1 and a second active portion T2A of the switch transistor T2.

The second semiconductor layer 212 is disposed on a side of the first semiconductor layer 207 away from the substrate 201, and the second semiconductor layer 212 includes a third active portion T3A of the compensation transistor T3 and a fourth active portion T4A of the first initialization transistor T4.

The light shielding layer 202 includes a first light shielding portion 202a disposed opposite to the first active portion T1A, a second light shielding portion 202b disposed opposite to the third active portion T3A, and a third light shielding portion 202c disposed opposite to the fourth active portion T4A. The light shielding layer 202 also includes a first connecting line 202e extending along a first direction X and a second connecting line 202d extending along a second direction Y, the first connecting line 202e is connected to two first light shielding portions 202a adjacent to each other in the first direction X, and the second connecting line 202d is connected to two first light shielding portions 202a adjacent to each other in the second direction Y, so that the light shielding layer 202 forms a grid structure. The second light shielding portion 202b and the third light shielding portion 202c are both located in the area enclosed by adjacent two of the first connecting lines 202e, adjacent two of the second connecting lines 202d, and four first light shielding portions 202a, that is, the second light shielding portion 202b and the third light shielding portion 202c are located in part of the meshes of the grid structure formed by the light shielding layer 202. The first direction X and the second direction Y are different. For example, the first direction X is a horizontal direction, and the second direction Y is a vertical direction. That is, the first direction X is a row direction, and the second direction Y is a column direction. Of course, the present application is not limited thereto. The first direction X and the second direction Y in the present application may also be at other angles.

An embodiment of the present application provides a display panel, which includes a substrate and a light shielding layer, a first semiconductor layer, and a second semiconductor layer disposed on the substrate, the first semiconductor layer forms a first active portion of a drive transistor, the second semiconductor layer forms a third active portion of a compensation transistor and a fourth active portion of a first initialization transistor, the light shielding layer includes a first light shielding portion disposed opposite to the first active portion, a second light shielding portion disposed opposite to the third active portion, and a third light shielding portion disposed opposite to the fourth active portion, the second light shielding portion can shield the third active portion, and the third light shielding portion can shield the fourth active portion, so as to prevent the third active portion of the compensation transistor and the fourth active portion of the first initialization transistor from being affected by light, thereby improving the photosensitivity and electrical properties of the compensation transistor and the first initialization transistor, so as to improve the problem of poor photosensitivity and electrical properties caused by missing of bottom gate of an oxide thin film transistor in a display device using LTPO technology.

Specifically, in the embodiments of the present application, the light shielding portion formed by the light shielding layer is disposed opposite to the active portion of the transistor, which means that the light shielding portion is at least disposed opposite to the channel portion of the active portion of the transistor, and the projection of the light shielding portion on the substrate overlaps with the projection of the channel portion of the transistor on the substrate. It can be understood that the active portion of each transistor includes a doping portion and a channel portion, and the channel portion is easily affected by light and causes performance changes. Therefore, the light shielding portion can be disposed opposite to the channel portion of the transistor. Specifically, for example, the second light shielding portion is disposed opposite to the third active portion of the compensation transistor, which means that the second light shielding portion is at least disposed opposite to the third channel portion of the compensation transistor.

In some embodiments, as shown in FIG. 6 and FIG. 8, the light shielding layer 202 includes a first light shielding portion 202a, a second light shielding portion 202b, and a third light shielding portion 202c. The first light shielding portion 202a is disposed opposite to the first active portion T1A of the drive transistor T1, the second light shielding portion 202b is disposed opposite to the third active portion T3A of the compensation transistor T3, and the third light shielding portion 202c is disposed opposite to the fourth active portion T4A of the first initialization transistor T4.

Specifically, the orthographic projection of the first active portion of the drive transistor on the substrate is located within the orthographic projection of the first light shielding portion on the substrate, the orthographic projection of the third active portion of the compensation transistor on the substrate is located within the orthographic projection of the second light shielding portion on the substrate, and the orthographic projection of the fourth active portion of the first initialization transistor on the substrate is located within the orthographic projection of the third light shielding portion on the substrate, thereby preventing light from irradiating to the first active portion of the drive transistor, the third active portion of the compensation transistor and the fourth active portion of the first initialization transistor, thereby improving the electrical properties and photosensitivity of the drive transistor, the compensation transistor and the first initialization transistor.

Specifically, the area of the first light shielding portion can be greater than or equal to the area of the first active portion of the drive transistor, the area of the second light shielding portion can be greater than or equal to the area of the third active portion of the compensation transistor, and the area of the third light shielding portion can be greater than or equal to the area of the fourth active portion of the first initialization transistor.

In some embodiments, as shown in FIG. 4, FIG. 6, and FIG. 8 , the display panel includes a plurality of repeating units 30 disposed in an array on the substrate, each repeating unit 30 includes two sub-pixels 31 disposed in a mirror-symmetrical manner, and in the repeating unit 30 , the light shielding layer 202 includes two first light shielding portions 202a, two second light shielding portions 202b, two third light shielding portions 202c, and a first connecting line 202e and a second connecting line 202d connecting adjacent two of the first light shielding portions 202a symmetrically disposed in the corresponding regions of the two sub-pixels 31. The second light shielding portion 202b is located between the third light shielding portion 202c and the first light shielding portion 202a and also disposed opposite to the gap between the adjacent two of the first light shielding portions 202a, and the two first light shielding portions 202a are mirror-symmetrical with respect to the two second light shielding portions 202b. Moreover, in the first direction X, the second light shielding portion 202b partially overlaps with the first light shielding portion 202a. The third light shielding portion 202c is located between adjacent two of the second connecting lines 202d. In the second direction Y, the third light shielding portion 202c partially overlaps with the first light shielding portion 202a.

The first connecting line 202e is disposed along the first direction X, the second connecting line 202d is disposed along the second direction Y, the first light shielding portion 202a is provided with a notch on the side away from the second light shielding portion 202b, and the first connecting line 202e is disposed at the notch. Adjacent two of the first connecting lines 202e overlap in the first direction X. The second connecting line 202d is located on the side of the central line of the first light shielding portion 202a in the second direction Y close to the second light shielding portion 202b, and adjacent two of the second connecting lines 202d overlap in the second direction Y. There is a gap between the second light shielding portion 202b and the first light shielding portion 202a, the first connecting line 202e and the second connecting line 202d, so that the second light shielding portion 202b is insulated from the first light shielding portion 202a. There is a gap between the third light shielding portion 202c and the first light shielding portion 202a, the first connecting line 202e and the second connecting line 202d, so that the third light shielding portion 202c is insulated from the first light shielding portion 202a. Optionally, there is a gap between adjacent second light shielding portions 202b, there is a gap between adjacent third light shielding portions 202c, and there is also a gap between adjacent second light shielding portions 202b and third light shielding portions 202c. The second light shielding portion 202b and/or the third light shielding portion 202c are in a floating state, that is, the second light shielding portion 202b and/or the third light shielding portion 202c are not connected to an electrical signal, and no electrical signal is applied to the second light shielding portion 202b and/or the third light shielding portion 202c. At least one of the first light shielding portion 202a, the first connecting line 202e, and the second connecting line 202d is connected to a high potential power line.

Specifically, it can be understood that the display panel may include a plurality of repeating units disposed in an array, and the sub-pixels in each repeating unit may refer to the design in a repeating unit in the embodiments of the present application.

Specifically, it can be understood that in the display panel, adjacent two of the sub-pixels are symmetrically disposed to increase the aperture ratio. The embodiments of the present application realize mesh structures of the first light shielding portion by symmetrically disposing the light shielding portions and connecting the first light shielding portions of each row and column by setting the first connecting line and the second connecting line. When the signal is input, the voltage drops of various parts of the first light shielding portion are similar or even the same, thereby improving the uniformity of the signal and the display effect.

Specifically, as shown in FIG. 8, it can be seen that the first connection line 202e connects the plurality of first light shielding portions 202a in the first direction X, and the second connection line 202d connects the plurality of first light shielding portions 202a in the second direction Y. The second connection line 202d connects the first light shielding portion 202a in the sub-pixel 31 of the current row with the first light shielding portion 202a in the sub-pixel 31 of the previous row, and the adjacent second connection line 202d connects the first light shielding portion 202a in the sub-pixel 31 of the current row with the first light shielding portion 202a in the sub-pixel 31 of the next row, and the two first light shielding portions 202a in the repeating unit 30 are connected to each other (not shown in the drawing, because the two first light shielding portions 202a in some repeating units are connected to each other to achieve a grid-like design), thereby achieving the connection of the first light shielding portions 202a in each row and column, so that the light shielding layer 202 forms a mesh structure, thereby achieving uniformity during signal transmission.

In some embodiments, as shown in FIG. 4, FIG. 7 and FIG. 9, different from the embodiment illustrated in FIG. 8, the light shielding layer 202 also includes a third connecting line (202f1, 202f2 as illustrated in FIG. 9), and within a repeating unit, at least one of the second light shielding portion 202b and the third light shielding portion 202c is connected to at least one of the first light shielding portion 202a, the first connecting line 202e, and the second connecting line 202d through the third connecting line. As illustrated in FIG. 9, the second light shielding portion 202b is connected to the first light shielding portion 202a and the second connecting line 202d through the third connecting line 202f1, and the third light shielding portion 202c is connected to the second connecting line 202d through the third connecting line 202f2. The adjacent second light shielding portions 202b and/or the adjacent third light shielding portions 202c are connected by the fourth connecting line 202g, so that the second light shielding portion 202b, the third light shielding portion 202c, the third connecting lines 202f1, 202f2, and the fourth connecting line 202g cooperate with the first light shielding portion 202a, the first connecting line 202e, and the second connecting line 202d to form a grid structure, further realizing the uniformity of signal transmission; and it can also replace the first connecting line 202e connecting adjacent two of the first light shielding portions 202a in the repeating unit, thereby reducing the number of first connecting lines 202e. At the same time, in the second direction Y, the line widths of the second light shielding portion 202b, the third light shielding portion 202c, the third connecting lines 202f1, 202f2, and the fourth connecting line 202g are all greater than the line width of the first connecting line 202e, which can further reduce the overall impedance of the light shielding layer 202 and further improve the uniformity of the signal.

Optionally, at least one of the first light shielding portion 202a, the second light shielding portion 202b, the third light shielding portion 202c, the first connection line 202e, the second connection line 202d, and the third connection lines 202f1 and 202f2 is connected to a high potential power line.

In some embodiments, as shown in FIG. 5 , the gate of the switch transistor T2 is connected to the first scan signal line Pscan, the first electrode of the switch transistor T2 is connected to the data line DATA, and the second electrode of the switch transistor T2 is connected to the first electrode of the drive transistor T1 at the first node A; the gate of the compensation transistor T3 is connected to the second scan signal line Nscan1, the first electrode of the compensation transistor T3 is connected to the gate of the drive transistor T1 at the second node Q, and the second electrode of the compensation transistor T3 is connected to the second electrode of the drive transistor T1; the gate of the first initialization transistor T4 is connected to the third scan signal line Nscan2, the first electrode of the first initialization transistor T4 is connected to the first initialization signal line VI-G, and the second electrode of the first initialization transistor T4 is connected to the gate of the drive transistor T1 at the second node B; the sub-pixel 31 further includes:
a first light emitting control transistor T5, a gate of the first light emitting control transistor T5 is connected to the light emitting control signal line EM, a first electrode of the first light emitting control transistor T5 is connected to the high potential power line VDD, and a second electrode of the first light emitting control transistor T5 is connected to the first electrode of the drive transistor T1 at a first node A;
a second light emitting control transistor T6, a gate of the second light emitting control transistor T6 is connected to the light emitting control signal line EM, and a first electrode of the second light emitting control transistor T6 and a second electrode of the drive transistor T1 are connected to a third node B;
a second initialization transistor T7, a gate of the second initialization transistor T7 is connected to the fourth scan signal line Pscan2, a first electrode of the second initialization transistor T7 is connected to the second initialization signal line VI-ANO, and a second electrode of the second initialization transistor T7 and a second electrode of the second light emitting control transistor T6 are connected to a fourth node C;
a third initialization transistor T8, a gate of the third initialization transistor T8 is connected to the fourth scan signal line Pscan2, a first electrode of the third initialization transistor T8 is connected to the third initialization signal line VI3, and a second electrode of the third initialization transistor T8 is connected to the first electrode of the drive transistor T1 at the first node A;
a storage capacitor Cst, one plate of the storage capacitor Cst is connected to the high potential power line VDD, and the other plate of the storage capacitor Cst is connected to the gate of the drive transistor T1 at the second node Q;
a boost capacitor Cboost, one plate of the boost capacitor Cboost is connected to the first scan signal line Pscan, and the other plate of the boost capacitor Cboost is connected to the second electrode of the first initialization transistor T4.

Specifically, as shown in FIG. 4 and FIG. 5, the display panel 2 further includes a light emitting layer 23, the light emitting layer 23 includes a light emitting device LED, the positive electrode of the light emitting device LED is connected to the second electrode of the second initialization transistor T7, and the negative electrode of the light emitting device LED is connected to the low potential power line VSS.

In some embodiments, as shown in FIG. 4, the display panel 2 further includes a first gate layer 209, a second gate layer 214, a first source-drain layer 216, and a second source-drain layer 218. The first gate layer 209 is disposed between the first semiconductor layer 207 and the second semiconductor layer 212, the second gate layer 214 is disposed between the second semiconductor layer 212 and the first source-drain layer 216, and the first source-drain layer 216 is disposed between the second gate layer 214 and the second source-drain layer 218. By making the display panel include the first gate layer, the second gate layer, the first source-drain layer, and the second source-drain layer, the process steps of the display panel can be reduced, and the masks required to form the display panel can be reduced.

In some embodiments, as shown in FIG. 4 to FIG. 6 and FIG. 10, the first semiconductor layer 207 includes a first active portion T1A of the drive transistor T1, a second active portion T2A of the switch transistor T2, a fifth active portion T5A of the first light emitting control transistor T5, a sixth active portion T6A of the second light emitting control transistor T6, a seventh active portion T7A of the second initialization transistor T7, and an eighth active portion T8A of the third initialization transistor T8. The first active portion T1A of the drive transistor T1 is disposed along the first direction X and connected to the second active portion T2A of the switch transistor T2, the fifth active portion T5A of the first light emitting control transistor T5, and the sixth active portion T6A of the second light emitting control transistor T6. The second active portion T2A of the switch transistor T2 and the fifth active portion T5A of the first light emitting control transistor T5 are disposed along the second direction Y. The sixth active portion T6A of the second light emitting control transistor T6 and the seventh active portion T7A of the second initialization transistor T7 are disposed along the second direction Y and connected to each other. The eighth active portion T8A of the third initialization transistor T8 is spaced apart from the first active portion T1A of the drive transistor T1, the second active portion T2A of the switch transistor T2, the fifth active portion T5A of the first light emitting control transistor T5, the sixth active portion T6A of the second light emitting control transistor T6, and the seventh active portion T7A of the second initialization transistor T7.

Specifically, it can be seen that within one repeating unit, the seventh active portions T7A of the second initialization transistors T7 of adjacent two of the sub-pixels 31 are connected.

In some embodiments, as shown in FIG. 4 to FIG. 7 and FIG. 11, the first gate layer 209 includes a first initialization signal line VI-G, a first scan signal line Pscan, a light emitting control signal line EM, a fourth scan signal line Pscan2, a gate T1G of a drive transistor T1, a gate T2G of a switch transistor T2, a gate T5G of a first light emitting control transistor T5, a gate T6G of a second light emitting control transistor T6, a gate T7G of a second initialization transistor T7, a gate T8G of a third initialization transistor T8 and a first plate Cst1 of a storage capacitor Cst. The first initialization signal line VI-G, the first scan signal line Pscan, the first plate Cst1 of the storage capacitor Cst, the light emitting control signal line EM and the fourth scan signal line Pscan2 are sequentially disposed and spaced from each other along the second direction Y.

Specifically, as can be seen from FIG. 11, the gate T2G of the switch transistor T2 is a part of the first scan signal line Pscan. It can be understood that, since the gates T2G of all the switch transistors T2 in sub-pixels of a row are connected to the same first scan signal line Pscan, when the first scan signal line Pscan is formed, the portion of the first scan signal line Pscan corresponding to the channel of the switch transistor T2 of each sub-pixel serves as the gate of the switch transistor T2 of each pixel unit. Therefore, the same structure is identified by two reference numerals. Similarly, the gate T1G of the drive transistor T1 serves as both the gate and the first plate Cst1 of the storage capacitor Cst, the portion of the light emitting control signal line EM corresponding to the channel of the first light emitting control transistor T5 serves as the gate T5G of the first light emitting control transistor T5, the portion of the light emitting control signal line EM corresponding to the channel of the second light emitting control transistor T6 serves as the gate T6G of the second light emitting control transistor T6, the portion of the fourth scan signal line Pscan2 corresponding to the channel of the second initialization transistor T7 serves as the gate T7G of the second initialization transistor T7, and a portion of the fourth scan signal line Pscan2 corresponding to the channel of the third initialization transistor T8 serves as the gate T8G of the third initialization transistor T8.

In some embodiments, as shown in FIG. 4 to FIG. 7 and FIG. 12, the second semiconductor layer 212 includes a third active portion T3A of the compensation transistor T3, a fourth active portion T4A of the first initialization transistor T4, and a second plate Cst2 of the storage capacitor Cst, the third active portion T3A of the compensation transistor T3 is connected to the fourth active portion T4A of the first initialization transistor T4, the second plate Cst2 of the storage capacitor Cst is disposed on one side of the third active portion T3A of the compensation transistor T3 along the first direction X, and a through hole 331 is provided on the second plate Cst of the storage capacitor Cst. By forming the second plate of the storage capacitor in the second semiconductor layer, a storage capacitor can be provided in the sub-pixel 31, and a through hole is provided on the second plate of the storage capacitor, so that the first electrode of the compensation transistor can be normally connected to the gate of the drive transistor.

Specifically, it can be understood that the second semiconductor layer forms the second plate of the storage capacitor, therefore, it is necessary to make the second plate of the storage capacitor have better electrical properties. The second plate of the storage capacitor can be doped to keep the electrical properties of the second plate of the storage capacitor consistent with or even higher than the electrical properties of the doped part of the active part, so that the electrical properties of the storage capacitor are better.

Specifically, by providing a through hole on the second plate of the storage capacitor, the first electrode of the compensation transistor can pass through the second plate of the storage capacitor and be connected to the gate of the drive transistor, so that the sub-pixel 31 works normally.

Specifically, as shown in FIG. 11 and FIG. 12, the first gate layer 209 also includes a first plate Cboost1 of the boost capacitor Cboost, the second semiconductor layer 212 also includes a second plate Cboost2 of the boost capacitor Cboost, the portion of the first scan signal line Pscan overlapping with the fourth active portion T4A of the first initialization transistor T4 forms the first plate Cboost1 of the boost capacitor Cboost, and the portion of the fourth active portion T4A of the first initialization transistor T4 overlapping with the first scan signal line Pscan forms the second plate Cboost 2 of the boost capacitor Cboost .

In some embodiments, as shown in FIG. 4 to FIG. 7 and FIG. 13, the second gate layer 214 includes a second scan signal line Nscan1, a third scan signal line Nscan2, a third initialization signal line VI3, a gate T3G of the compensation transistor T3, and a gate T4G of the first initialization transistor T4, the third scan signal line Nscan2, the second scan signal line Nscan1 and the third initialization signal line VI3 are sequentially disposed along the second direction Y.

In some embodiments, as shown in FIG. 4 to FIG. 7 and FIG. 14 , the first source-drain layer 216 includes a first data connection line L1, a first electrode T2S of the switch transistor T2, a first electrode T3S of the compensation transistor T3, a second electrode T3D of the compensation transistor T3, a first electrode T4S of the first initialization transistor T4, a second electrode T4D of the first initialization transistor T4, a first electrode T5S of the first light emitting control transistor T5, a second electrode T5D of the first light emitting control transistor T5, a first electrode T6S of the second light emitting control transistor T6, a second electrode T6D of the second light emitting control transistor T6, a first electrode T7S of the second initialization transistor T7, a second electrode T7D of the second initialization transistor T7, a first electrode T8S of the third initialization transistor T8, a second electrode T8D of the third initialization transistor T8, and a second initialization signal line VI-ANO.

Specifically, as shown in FIG. 14 , it can be understood that, the electrodes of each transistor are connected together, and in order to improve the aperture ratio in actual design, the electrodes of each transistor will share the same structure, therefore, in FIG. 14, multiple reference numerals are used to identify the same structure, for example, a structure is used as both the first electrode T3S of the compensation transistor T3 and the second electrode T4D of the first initialization transistor T4, and it can be seen from FIG. 5 that this is the location where the second node Q is connected. Similarly, other structures will also serve as multiple electrodes, and the location of each node can be determined accordingly.

Specifically, as shown in FIG. 11 and FIG. 14, the first initialization signal line VI-G is connected to the first electrode T4S of the first initialization transistor T4 through the first connection terminal K1. In view of the small spacing between the projections of the first initialization signal line VI-G and the third scan signal line Nscan2 on the substrate, a via is directly formed in the region corresponding to the first electrode of the first initialization transistor to connect the first initialization signal line. However, there is a problem that the via is formed on the third scan signal line Nscan2. Therefore, a first connection terminal K1 may be provided on the first source-drain layer, and the first electrode of the first initialization transistor T4 is connected through the first connection terminal K1. Meanwhile, a via is formed in the region corresponding to the first connection terminal K1, so that the first connection terminal K1 is connected to the first initialization signal line VI-G, thereby realizing the connection between the first initialization signal line VI-G and the first electrode T4S of the first initialization transistor T4. Moreover, the first connection terminal K1 is provided on the symmetry axis of the two symmetrically disposed sub-pixels 31, so that the first electrodes of the first initialization transistors T4 in the two symmetrically disposed sub-pixels 31 can be connected to the first initialization signal line through the same first connection terminal K1, thereby reducing the number of via holes and improving the yield.

Specifically, as shown in FIG. 6, FIG. 7, FIG. 14 and 15, since the high potential power line VDD has no overlap with the first electrode T5S of the first light emitting control transistor T5, and the high potential power line VDD will be connected to one plate of the storage capacitor, it is necessary to set a second connection terminal K2 so that the second connection terminal K2 is connected to the high potential power line VDD, therefore, the signal of the high potential power line VDD can be transmitted to the first electrode T5S of the first light emitting control transistor T5, and a third connection terminal K3 can be set so that the third connection terminal K3 is connected to the second plate Cst2 of the storage capacitor Cst, thereby realizing the connection between one plate of the storage capacitor Cst, the first light emitting control transistor T5 and the high potential power line VDD.

Specifically, as shown in FIG. 6 to FIG. 14, the first electrode T3S of the compensation transistor T3 is connected to the gate T1G of the drive transistor T1. Therefore, a fourth connection terminal K4 can be provided on the first source-drain layer, and the fourth connection terminal K4 is connected to the gate T1G of the drive transistor T1 through the through hole 331, thereby realizing the connection between the gate of the drive transistor T1 and the first electrode T3S of the compensation transistor T3.

In some embodiments, as shown in FIG. 4 to FIG. 15, within the repeating unit 30, the second source-drain layer 218 includes two data lines DATA, an initialization signal connection line L3, two high potential power lines VDD and a second data connection line L2, the two data lines DATA are disposed in a mirror-symmetrical manner, the two high potential power lines VDD are disposed in a mirror-symmetrical manner, and the initialization signal connection line L3 and the second data connection line L2 are disposed in a mirror-symmetrical manner.

Specifically, the high potential power line VDD may be connected to the second connection terminal K2 through the via hole, and the data line may be connected to the first electrode T2S of the switch transistor T2 through the via hole.

Specifically, as shown in FIG. 15, the second source-drain layer 218 further includes a fifth connection terminal K5, and the fifth connection terminal K5 is connected to the second electrode T6D of the second light emitting control transistor T6 and an electrode of the light emitting device.

Specifically, it can be understood that the design of the sub-pixel 31 in the embodiment of the present application is shown in the display area, however, the connection points of some routing lines are located in the non-display area. Therefore, some routing lines may not be connected together, but in fact, they will be connected. For example, in order to adopt the technology of fan-out in active area (FIAA) for the data line DATA, a first data connection line L1 disposed along the first direction and a second data connection line L2 disposed along the second direction will be set, and will be connected to the data line outside the display area. However, the embodiment of the present application shows the design of the sub-pixel 31, and therefore, its connection points are not shown, but in fact, they will be connected.

At the same time, in order to realize the mesh structure design of the initialization signal lines in the embodiments of the present application, the initialization signal connection line L3 will be set. The initialization signal connection line L3 can realize the mesh structure design of at least one of the first initialization signal line, the second initialization signal line and the third initialization signal line. Similarly, the initialization signal connection line will be connected to the initialization signal line.

For example, the first initialization signal line will be connected to the initialization signal connection line outside the display area, thereby realizing the mesh structure design of the first initialization signal line. Similarly, the mesh structure design of the second initialization signal line and the mesh structure design of the third initialization signal line can be realized. However, the embodiments of the present application are not limited to this. Part of the initialization signal connection line can be connected to one of the first initialization signal line, the second initialization signal line and the third initialization signal line, part of the initialization signal connection line can be connected to another one of the first initialization signal line, the second initialization signal line and the third initialization signal line, and part of the initialization signal connection line can also be connected to still another one of the first initialization signal line, the second initialization signal line and the third initialization signal line, thereby realizing the mesh structure design of each initialization signal line.

In some embodiments, as shown in FIG. 16, FIG. 16 shows the location of the first via hole 341, where the first via hole 341 refers to a via hole etched from the first source-drain layer to the first semiconductor layer or the first gate layer.

In some embodiments, as shown in FIG. 17, FIG. 17 shows the location of the second via hole 342, where the second via hole 342 refers to a via hole etched from the first source-drain layer to the second semiconductor layer or the second gate layer.

In some embodiments, as shown in FIG. 18, FIG. 18 shows the location of the third via hole 343, where the third via hole 343 refers to a via hole etched from the second source-drain layer to the first source-drain layer.

In some embodiments, as shown in FIG. 19, FIG. 19 shows the location of the fourth via hole 344, where the fourth via hole 344 refers to a via hole etched from the anode of the light emitting layer to the second source-drain layer.

Specifically, as shown in FIG. 4, the display panel 2 further includes a first barrier layer 203, a second barrier layer 205, a buffer layer 206, a first gate insulating layer 208, a first interlayer insulating layer 211, a second gate insulating layer 213, a second interlayer insulating layer 215, a first planarization layer 217 and a second planarization layer 219.

Specifically, as shown in FIG. 4, the display panel 2 further includes a light emitting layer 23, and the light emitting layer 23 includes a pixel electrode layer 221, a pixel definition layer 222, a light emitting material layer, a common electrode layer and a support column 223.

Specifically, the first electrode of the transistor in the above embodiment is a source, and the second electrode is a drain; or the first electrode of the transistor in the above embodiment is a drain, and the second electrode is a source.

Specifically, the first scan signal line Pscan, the second scan signal line Nscan1, the third scan signal line Nscan2, the fourth scan signal line Pscan2 and the light emitting control signal line EM can be respectively connected to different gate drive circuits. Specifically, five groups of gate drive circuits can be used to output signals to the first scan signal line Pscan, the second scan signal line Nscan1, the third scan signal line Nscan2, the fourth scan signal line Pscan2 and the light emitting control signal line EM, respectively. Among them, the gate drive circuit connected to the first scan signal line Pscan can adopt bilateral drive, and the other gate drive circuits adopt unilateral drive.

Specifically, the material of the first semiconductor layer includes a silicon semiconductor material, and specifically may be a low temperature polysilicon.

Specifically, the material of the second semiconductor layer includes an oxide semiconductor material, specifically a metal oxide semiconductor material, and more specifically, indium gallium zinc oxide.

Specifically, the material of the light shielding layer includes a metal material.

Specifically, the drive transistor, the switch transistor, the first light emitting control transistor, the second light emitting control transistor, the second initialization transistor and the third initialization transistor are all P-type transistors, and the first initialization transistor and the compensation transistor are all N-type transistors.

Specifically, the above embodiments respectively describe the display panel in detail from the sub-pixel structure, layer structure, specific structure, materials, and potential of each layer in the display panel. It can be understood that when there is no conflict between the embodiments, the embodiments can be combined.

Meanwhile, an embodiment of the present application provides a display device, which includes a display panel as described in any of the above embodiments.

In the above embodiments, the description of each embodiment has its own emphasis. For parts that are not described in detail in a certain embodiment, reference can be made to the relevant descriptions of other embodiments.

Some embodiments of the present application have been described in detail above. Specific examples have been used to illustrate the principles and implementation methods of the present application. The descriptions of the embodiments above are only for the purpose of helping to understand the technical solutions and core ideas of the present application. Those of ordinary skill in the art should understand that modifications can still be made to the technical solutions described in the foregoing embodiments, or equivalent substitutions can be made to some of the technical features. These modifications or substitutions do not cause the essence of the corresponding technical solutions to deviate from the scope of the technical solutions of the embodiments of the present application.

## Claims

1. A display panel, comprising a substrate and a plurality of sub-pixels disposed on the substrate,
wherein each of the sub-pixels comprises a drive transistor, a switch transistor, a compensation transistor and a first initialization transistor;
the switch transistor and the drive transistor are connected to a first node;
an electrode of the compensation transistor, an electrode of the first initialization transistor and the drive transistor are connected to a second node; and
another electrode of the compensation transistor and the drive transistor are connected to a third node,
the display panel further comprising:
a light shielding layer disposed on the substrate;
a first semiconductor layer disposed on a side of the light shielding layer away from the substrate, the first semiconductor layer comprising a first active portion of the drive transistor and a second active portion of the switch transistor; and
a second semiconductor layer disposed on a side of the first semiconductor layer away from the substrate, the second semiconductor layer comprising a third active portion of the compensation transistor and a fourth active portion of the first initialization transistor,
wherein the light shielding layer comprises: a plurality of first light shielding portions each disposed opposite to the first active portion; a plurality of second light shielding portions each disposed opposite to the third active portion; a plurality of third light shielding portions each disposed opposite to the fourth active portion; a plurality of first connecting lines each extending along a first direction; and a plurality of second connecting lines each extending along a second direction different from the first direction; and
each of the first connecting lines connects two of the first light shielding portions adjacent in the first direction to each other, and each of the second connecting lines connects two of the first light shielding portions adjacent in the second direction to each other.

2. The display panel according to claim 1, wherein the second light shielding portions and the third light shielding portions are located in a region surrounded by two adjacent ones of the first connecting lines, two adjacent ones of the second connecting lines, and four of the first light shielding portions.

3. The display panel according to claim 2, wherein a gap exists between each of the second light shielding portions and each of the four of the first light shielding portions, the two adjacent ones of the first connecting lines and the two adjacent ones of the second connecting lines;
a gap exists between each of the third light shielding portions and each of the four of the first light shielding portions, the two adjacent ones of the first connecting lines and the two adjacent ones of the second connecting lines; and
at least one of each of the second light shielding portions and each of the third light shielding portions is in a floating state.

4. The display panel according to claim 3, wherein a gap exists between two of the second light shielding portions;
a gap exists between the two of the third light shielding portions; and
a gap exists between each of the two of the second light shielding portions and each of the two of the third light shielding portions.

5. The display panel according to claim 2, wherein the light shielding layer further comprises a plurality of third connecting lines; and
at least one of one of the two of the second light shielding portions or one of the two of the third light shielding portions is connected with at least one of one of the four of the first light shielding portions, one of the two adjacent ones of the first connecting lines, and one of the two adjacent ones of the second connecting lines through at least one of the third connecting lines.

6. The display panel according to claim 5, wherein the light shielding layer further comprises a plurality of fourth connecting lines; and
the two of the second light shielding portions are connected to each other thought one of the fourth connecting lines, and/or the two of the third light shielding portions are connected to each other thought one of the fourth connecting lines.

7. The display panel according to claim 5, wherein at least one of each of the first light shielding portions, each of the second light shielding portions, each of the third light shielding portions, each of the first connection lines, each of the second connection lines, or each of the third connection lines is connected with a high potential power line.

8. The display panel according to claim 1, wherein an orthographic projection of the first active portion on the substrate is located within an orthographic projection of one of the first light shielding portions on the substrate;
an orthographic projection of the third active portion on the substrate is located within an orthographic projection of one of the second light shielding portions on the substrate; and
an orthographic projection of the fourth active portion on the substrate is located within an orthographic projection of one of the third light shielding portions on the substrate.

9. The display panel according to claim 8, wherein each of the second light shielding portions partially overlaps at least one of the first light shielding portions in the first direction; and
each of the third light shielding portions is located between two adjacent ones of the second connecting lines, and partially overlaps at least one of the first light shielding portions in the second direction.

10. The display panel according to any one of claims 1-9, wherein a gate of the switch transistor is connected with a first scan signal line, a first electrode of the switch transistor is connected with one of a plurality of data lines, and a second electrode of the switch transistor and a first electrode of the drive transistor are connected to the first node;
a gate of the compensation transistor is connected with a second scan signal line, a first electrode of the compensation transistor and a gate of the drive transistor are connected to the second node, and a second electrode of the compensation transistor and a second electrode of the drive transistor are connected to the third node;
a gate of the first initialization transistor is connected with a third scan signal line, a first electrode of the first initialization transistor is connected with a first initialization signal line, and a second electrode of the first initialization transistor is connected to the second node; and
the each of the sub-pixels further comprises:
a first light emitting control transistor having a gate connected with a light emitting control signal line, a first electrode connected with one of a plurality of high potential power lines, and a second electrode connected to the first node;
a second light emitting control transistor having a gate connected with the light emitting control signal line, a first electrode connected to the third node, and a second electrode connected to a fourth node;
a second initialization transistor having a gate connected to a fourth scan signal line, a first electrode connected with a second initialization signal line, and a second electrode connected to the fourth node;
a third initialization transistor having a gate connected with the fourth scan signal line, a first electrode connected with a third initialization signal line, and a second electrode connected to the first node;
a storage capacitor having a first plate connected to the second node and a second plate connected with the one of the plurality of high potential power lines; and
a boost capacitor having one plate connected to the first scan signal line and another plate connected to the second electrode of the first initialization transistor.

11. The display panel according to claim 10, wherein each of the drive transistor, the switch transistor, the first light emitting control transistor, the second light emitting control transistor, the second initialization transistor and the third initialization transistor is a P-type transistor; and
each of the first initialization transistor and the compensation transistor is an N-type transistor.

12. The display panel according to claim 10, wherein a material of the first semiconductor layer comprises a silicon semiconductor material, and a material of the second semiconductor layer comprises an oxide semiconductor material.

13. The display panel according to claim 10, wherein the second semiconductor layer further comprises the second plate of the storage capacitor; and
the second plate of the storage capacitor is disposed opposite to the first active portion and provided with a through hole.

14. The display panel according to claim 10, wherein the first semiconductor layer further comprises a fifth active portion of the first light emitting control transistor, a sixth active portion of the second light emitting control transistor, a seventh active portion of the second initialization transistor, and an eighth active portion of the third initialization transistor;
the first active portion extends along the first direction and is connected with the second active portion, the fifth active portion, and the sixth active portion;
each of the second active portion, the fifth active portion, the sixth active portion and the seventh active portion extends along the second direction;
the sixth active portion is connected with the seventh active portion; and
the eighth active portion is spaced apart from the first active portion, the second active portion, the fifth active portion, the sixth active portion, and the seventh active portion.

15. The display panel according to claim 10, further comprising:
a first gate layer disposed between the first semiconductor layer and the second semiconductor layer, wherein the first gate layer comprises the first initialization signal line, the first scan signal line, the light emitting control signal line, the fourth scan signal line, the gate of the drive transistor, the gate of the switch transistor, the gate of the first light emitting control transistor, the gate of the second light emitting control transistor, the gate of the second initialization transistor, the gate of the third initialization transistor and the first plate of the storage capacitor, and wherein the first initialization signal line, the first scan signal line, the first plate of the storage capacitor, the light emitting control signal line and the fourth scan signal line are sequentially arranged at intervals along the second direction;
a second gate layer disposed on a side of the second semiconductor layer away from the substrate, wherein the second gate layer comprises the second scan signal line, the third scan signal line, the third initialization signal line, the gate of the compensation transistor and the gate of the first initialization transistor, and wherein the third scan signal line, the second scan signal line and the third initialization signal line are sequentially arranged along the second direction;
a first source-drain layer disposed on a side of the second gate layer away from the substrate, the first source-drain layer comprising a first data connection line, the first electrode of the switch transistor, the first electrode and the second electrode of the compensation transistor, the first electrode and the second electrode of the first initialization transistor, the first electrode and the second electrode of the first light emitting control transistor, the first electrode and the second electrode of the second light emitting control transistor, the first electrode and the second electrode of the second initialization transistor, the first electrode and the second electrode of the third initialization transistor, and the second initialization signal line; and
a second source-drain layer disposed on a side of the first source-drain layer away from the substrate, the second source-drain layer comprising the data lines, the high potential power lines, a plurality of second data connection lines and a plurality of initialization signal connection lines extending along the second direction.

16. The display panel according to claim 15, wherein the display panel comprises a plurality of repeating units arranged in an array on the substrate, each of the repeating units comprising two mirror-symmetrical ones of the sub-pixels, two mirror-symmetrical ones of the data lines, two mirror-symmetrical ones of the high potential power lines, and one of the second data connection lines and one of the initialization signal connection lines being mirror-symmetrical,
wherein the two mirror-symmetrical ones of the high potential power lines are located between the one of the second data connection lines and the one of the initialization signal connection lines, and each of the one of the second data connection lines and the one of the initialization signal connection lines is located between one of the two mirror-symmetrical ones of the high potential power lines and one of the two mirror-symmetrical ones of the data lines.

17. The display panel according to claim 16, wherein, within the each of the repeating units, the light shielding layer comprises two mirror-symmetrical ones of the first light shielding portions, two mirror-symmetrical ones of the second light shielding portions, two mirror-symmetrical ones of the third light shielding portions, two mirror-symmetrical ones of the first connecting lines and two mirror-symmetrical ones of the second connecting lines corresponding to the two mirror-symmetrical ones of the sub-pixels;
each of the two mirror-symmetrical ones of the second light shielding portions is located between each of the two mirror-symmetrical ones of the third light shielding portions and each of the two mirror-symmetrical ones of the first light shielding portions, and disposed in a gap between the two mirror-symmetrical ones of the first light shielding portions; and
the two mirror-symmetrical ones of the first light shielding portions are mirror-symmetrical with respect to the two mirror-symmetrical ones of the second light shielding portions.

18. The display panel according to claim 17, wherein a side of each of the two mirror-symmetrical ones of the first light shielding portions away from the two mirror-symmetrical ones of the second light shielding portions is provided with a notch, and one of the two mirror-symmetrical ones of the first connecting lines is provided at the notch.

19. The display panel according to claim 17, wherein each of the two mirror-symmetrical ones of the second connecting lines is located on a side of a central line of one of the two mirror-symmetrical ones of the first light shielding portions in the second direction close to the two mirror-symmetrical ones of the second light shielding portions; and
two adjacent ones of the second connecting lines overlap in the second direction.

20. A display device, comprising the display panel according to any one of claim 1-19.
